# EUROPÄISCHE PATENTSCHRIFT

(11) **EP 3 728 695 B1**
(45) Veröffentlichungstag und Bekanntmachung des Hinweises auf die Patenterteilung: **03.08.2022**
(21) Anmeldenummer: 18829386.4
(22) Anmeldetag: 20.12.2018
(51) Int. Cl.: C23C 28/00, C23C 28/04, C23C 14/06, C23C 30/00

(54) **KORROSIONS- UND EROSIONSBESTÄNDIGE BESCHICHTUNG FÜR TURBINENSCHAUFELN VON GASTURBINEN**
CORROSION- AND EROSION-RESISTANT COATING FOR TURBINE BLADES OF GAS TURBINES
REVÊTEMENT ANTI-CORROSION ET ANTI-ÉROSION POUR PALES DE TURBINES À GAZ

(30) Priorität: 22.12.2017 US 201762609650 P
(43) Veröffentlichungstag der Anmeldung: 28.10.2020
(73) Patentinhaber: Oerlikon Surface Solutions AG, Pfäffikon, 8808 Pfäffikon, SZ (CH)
(72) Erfinder: RAMM, Juergen, 7304 Maienfeld (CH); BOLVARDI, Hamid, 7000 Chur (CH); JARRY, Oliver, 50670 Köln (DE); SHANG, Lin, 7310 Bad Ragaz (CH); WIDRIG, Beno, 7310 Bad Ragaz (CH); JERG, Carmen, 6800 Feldkirch (DE)
(74) Vertreter: Misselhorn, Hein-Martin
(86) Internationale Anmeldenummer: PCT/EP2018/086371
(87) Internationale Veröffentlichungsnummer: WO 2019/122229

(56) Entgegenhaltungen:
- WO-A2-2014/170005
- STUBER M ET AL: "Magnetron sputtering of hard Cr-Al-N-O thin films", SURFACE AND COATINGS TECHNOLOGY, Bd. 203, Nr. 5-7, 1. Mai 2008 (2008-05-01) , Seiten 661-665, XP025656895, ELSEVIER B.V., AMSTERDAM [NL] ISSN: 0257-8972, DOI: 10.1016/J.SURFCOAT.2008.04.083 [gefunden am 2008-05-01]
- KNOTEK O ET AL: "Diffusion barrier coatings with active bonding, designed for gas turbine blades", SURFACE AND COATINGS TECHNOLOGY, Bd. 68/69, Dezember 1994 (1994-12), Seiten 22-26, XP055563396, Elsevier B.V., Amsterdam [NL] ISSN: 0257-8972, DOI: 10.1016/0257-8972(94)90132-5

## Beschreibung

Die vorliegende Erfindung betrifft Schaufeln für Gasturbinen mit einer eine verbesserte Erosions- und Korrosionsbeständigkeit verleihenden Beschichtung sowie ein Verfahren zur Herstellung derselben.

### TECHNISCHER HINTERGRUND

Komponenten von Gasturbinen sind einem Korrosionsmedium ausgesetzt. Zum Schutz dieser Bauteile vor Korrosion ist es bekannt Beschichtungen aufzubringen. Unter anderem kommen hier physikalische Beschichtungen, die aus der Gasphase abgeschieden wurden zum Einsatz Gemäss herkömmlichen Stand der Technik werden TiN/Ti, TiN/TiAIN und TiAIN Schichtsysteme eingesetzt. Diese zeigen verbesserte Erosionsbeständigkeit, aber beispielsweise bei Anwendungen auf hochchromhaltigen Stahlsubstraten ungenügende Korrosionsbeständigkeit.

Eine Weiterentwicklung stellt die DE102015212588 dar. Diese beschreibt ein Beschichtungssystem für ein korrosiv beanspruchtes Substrat mit einer Oberfläche, mindestens umfassend eine erste, zweite und dritte Schicht, bei der
- die zwischen der Oberfläche des Substrats und der zweiten Schicht angeordnete erste Schicht als Haftvermittlerschicht ausgebildet ist,
- die zweite Schicht eine duktile metallische Schicht mit einer Kolumnarstruktur ist, und
- die auf der vom Substrat weggewandten Seite der zweiten Schicht angeordnete dritte Schicht eine keramische Oxidschicht mit einer Härte von mindestens 20 GPa ist.

Die Härteangabe in der Einheit GPa bezieht sich auf den Druck, den die Beschichtung dem Eindringen eines Gegenstands entgegensetzen kann.

Die Ausbildung der ersten Schicht gemäss Stand der Technik als Haftvermittlerschicht sorgt für eine höhere Haftung zwischen Grundwerkstoff und der zweiten Schicht des Beschichtungssystems.

Die zweite Schicht schützt das Substrat kathodisch durch seine Funktion als Opferanode. Die Duktilität der zweiten Schicht dient zum Abfangen von Dehnungen bei schwingender Belastung, ohne dass Risse in der Schicht auftreten. Die Kolumnarstruktur der zweiten Schicht dient zum Ausgleich von Eigenspannungen, die durch die dritte Schicht verursacht werden.

Die dritte Schicht des Beschichtungssystems weist vorzugsweise Aluminiumoxid und/oder Chromoxid und/oder ein Aluminium-Chrom-Oxid in Mischkristallstruktur auf. Sie kann auch vollständig aus diesen Oxiden bestehen. Durch die Oxide ist die dritte Schicht beständig gegen Oxidation, da sie bereits aus mindestens einem Oxid besteht und damit bei hohen Temperaturen eingesetzt werden kann. Die dritte Schicht hat eine sehr dichte Struktur. Die dritte Schicht wirkt u.a. als Korrosionsschutz für die zweite Schicht. Weiterhin wirkt die dritte Schicht auf Grund ihrer keramischen Beschaffenheit isolierend, wodurch vorteilhaft galvanische Effekte unterbunden werden. Weiterhin ist die dritte Schicht wesentlich härter als der Grundwerkstoff und wirkt deshalb für die darunter liegenden Lagen und den Grundwerkstoff vorteilhaft als Schutz gegen Erosion, besonders gegen Tropfenschlag- und Partikelerosion. Vorzugsweise beträgt die Härte der dritten Schicht etwa 25 GPa.

Ebenfalls bekannt ist ein Verfahren zum Herstellen eines Beschichtungssystems für ein korrosiv beanspruchtes Substrat, umfassend drei Schichten entsprechend des erfindungsgemäßen Beschichtungssystems, wobei das Material aller Schichten durch physikalische Gasphasenabscheidung (physical vapour deposition, PVD) aufgetragen wird. Das Verfahren ist vorteilhaft, weil eine Wärmebehandlung nicht erforderlich ist. Weiterhin weisen durch PVD aufgetragene Schichten eine vorteilhafte Oberflächenrauigkeit auf, die gute aerodynamische Eigenschaften bewirkt.

Die PVD Schichten des Beschichtungssystems werden gemäss Stand der Technik durch kathodische Funkenverdampfung und/oder durch Sputtern aufgetragen.

Nachteilig bei dem 3 Schichten umfassenden Schichtsystem gemäss Stand der Technik ist allerdings die Tatsache, dass die dritte sehr harte Oxidschicht zu wenig Elastizität besitzt und dem bei Partikeleinschlag gegenüber unbeschadet zu bleiben. Hierdurch kann sie ihre Wirkung als Schutzschicht für die zweite Schicht lokal verlieren

Die WO 2014/17005 A2 zeigt eine Oxidationsschutzschicht auf Chrombasis für Substrate, welche hohen Temperaturen ausgesetzt werden. Die WO 2014/17005 A2 beschreibt damit Schichten, die einen guten Oxidationsschutz bieten.

### DIE DER ERFINDUNG ZU GRUNDE LIEGENDE AUFGABE

Der vorliegenden Erfindung liegt daher die Aufgabe zugrunde ein Beschichtungssystem für Komponenten von Gasturbinen anzugeben, das eine verbesserte Errosions- und Korrosionsbeständigkeit aufweist.

### DIE ERFINDUNGSGEMÄSSE LÖSUNG

Erfindungsgemäss wird die Aufgabe durch eine Komponente gemäss Anspruch 1 gelöst. Die erfindungsgemässe Komponente hat eine erosions- und korrosionsbeständigen Beschichtung mit einer Funktionsschicht und einer Zwischenschicht, die zwischen dem Turbinenschaufelsubstrat und der Funktionsschicht angeordnet ist. Die Komponente ist eine Turbinenschaufel.

Im Einzelnen kann man sagen, dass die Erfindung eine Turbinenschaufel einer Turbine, insbesondere einer Gasturbine bereitstellt, die eine Beschichtung zur Erhöhung der Erosions- und der Korrosionsbeständigkeit trägt, wie nachfolgend geschildert.

Die erfindungsgemäße Beschichtung ist vorzugsweise unmittelbar auf der Komponente aufgebracht. Sie zeichnet sich dadurch aus, dass sie aus einer Funktionsschicht und eine Zwischenschicht besteht. Dabei ist die Zwischenschicht zwischen dem Turbinenschaufelsubstrat und der Funktionsschicht angeordnet. Die Funktionsschicht besteht aus den Elementen Al, Cr, O und N.

Durch die vorliegende Erfindung kann insbesondere eine Verlängerung der Lebensdauer von Turbinenschaufeln in Gasturbinen erreicht werden, indem der Verschleiss derselben reduziert und gleichzeitig die Zeiten zwischen notwendigen Serviceintervallen vergrössert werden.

Erfindungsgemäß wird die Erosionsbeständigkeit des Grundmaterials gegenüber Einschlag von Festkörperpartikeln, gegenüber Tropfenschlag und auch gegenüber Blasenbildung erhöht.

Die Funktionsschicht enthält kubisch flächenzentriertes (Fm-3m) CrN und AIN. Das führt zu einer hohen Schichthärte bei verbessertem Elastizitätsmodul. Daher ist die erfindungsgemäße Lösung insoweit der spröden dritten Schicht überlegen, die die DE 10 2015 212 588 bisher als außenliegende Schicht vorschlägt. Wie später noch näher erläutert wird liegt der Erfindung zusätzlich die Erkenntnis zu Grunde, dass eine Funktionsschicht in Gestalt einer reinen Al-Cr-N Schicht keine gute Korrosionsbeständigkeit im Salzsprühtest zeigt. Erst die Zugabe von Sauerstoff bei der Synthese von Al-Cr-O-N erhöht die Korrosionsbeständigkeit, was die endgültige Stärke der Erfindung ausmacht.

Zum Zwecke der Erhöhung der Korrosionsbeständigkeit wird zwischen Substrat und Funktionsschicht eine Zwischenschicht gemäß Anspruch 1 aufgebracht werden, die angepasst ist sowohl an das spezifische Substratmaterial, beispielsweise den Cr-Gehalt des Stahls, als auch an die spezielle korrosive Umgebung, gegenüber der ein Schutz erzielt werden soll, also beispielsweise gegenüber Chlor oder Schwefel.

### BEVORZUGTE WEITERBILDUNGSMÖGLICHKEITEN

Es bestehen folgende optionale Möglichkeiten die Erfindung noch weiter zu verfeinern:
- Die Zwischenschicht umfasst ein Schichtsystem aus Cr und/oder AlCr und/oder Al-Cr-O, wobei die Cr-Lagen, falls vorhanden, jeweils weniger als 1µm dick sind.
- Vorzugsweise besteht die Zwischenschicht aus einem Schichtsystem aus AlCr und Al-Cr-O.
- Die Funktionsschicht kann eine Monolagenschicht oder eine Multilagenschicht sein.

Unter einer Multilagenschicht im Sinne der Erfindung wird - klar bevorzugt - ein Stapel mehrerer unmittelbar aufeinanderliegender Schichten verstanden, von denen jede die vom Anspruch 1 für die Funktionsschicht geforderte Zusammensetzung aufweist. Lediglich ausnahmsweise, zur Vermeidung patentrechtlicher Umgehungsversuche sei gesagt, dass eine Multilagenschicht im Sinne der Erfindung auch dann noch gegeben sein kann, wenn sich zwischen mehreren Funktionsschichten der geforderten Zusammensetzung alibimäßig eine die Funktionalität nicht wesentlich verschlechternde Schicht befindet.
- Die Sinngemäß gleiche Definition gilt, übertragen, auch dort, wo in Bezug auf die Zwischenschicht von einer Multilagenschicht die Rede ist. Unter einer eine Zwischenschicht bildenden Multilagenschicht im Sinne der Erfindung wird dann - klar bevorzugt - ein Stapel mehrerer unmittelbar aufeinanderliegender Schichten verstanden, von denen jede die vom betreffenden Anspruch für die Zwischenschicht geforderte Zusammensetzung aufweist.
- Falls die Funktionsschicht eine Multilagenstruktur ist, ist es vorteilhaft wenn in ihr sich das Al/Cr Verhältnis und/oder das O/N Verhältnis über zumindest einen Teil der Schichtdicke periodisch und/oder zumindest über einen Teil der Schichtdicke aperiodisch ändern.
- Besonders bevorzugt liegt das Verhältnis von Al zu Cr (Al/Cr) Atomen in der Funktionsschicht zwischen 4 und 1 und noch besser zwischen 2 und 1.5.
- Weiterhin ist bevorzugt wenn das Verhältnis von O zu N Atomen (O/N) in der Funktionsschicht zwischen 0.2 und 1.5, besonders bevorzugt zwischen 0.4 und 1 liegt.
- Es ist vorteilhaft wenn die Funktionsschicht eine Indentationshärte (HIT) von mindestens 25 GPa, bevorzugt grösser als 30 GPa aufweist, wobei die Indentationshärte (HIT) bei Raumtemperatur über eine Martenshärtemessung auf dem Fisherscope H100c gemäss den ISO14577-1 Vorschriften ermittelt wird.
- Die Funktionsschicht vorteilhafter Weise einen Elastizitätsmodul (EIT) von mindestens 280 GPa, bevorzugt grösser als 300 GPa, wobei der Elastizitätsmodul (EIT) bei Raumtemperatur über eine Martenshärtemessung auf dem Fisherscope H100c gemäss den IS014577-1 Vorschriften ermittelt wird.
- Die Rauhigkeit liegt bevorzugt mit Ra zwischen 0.1µm und 0.6µm und/oder mit Rz zwischen 1µm und 8µm.

### GENERELLE INFORMATIONEN ZUR ERFINDUNG

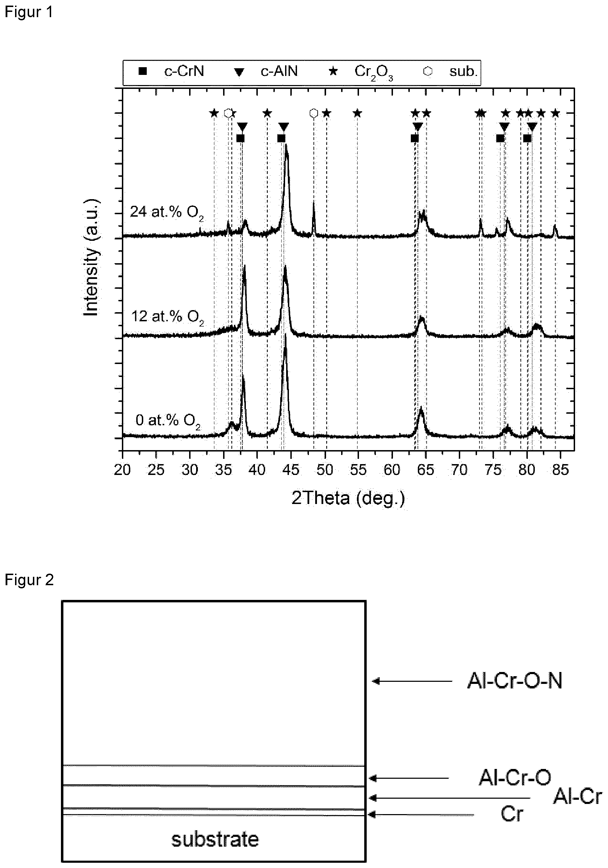

Sodann ist im Hinblick auf die Funktionsweise der Erfindung Folgendes zu erläutern:
Es ist insbesondere ein Vorteil, wenn das Röntgenbeugungsspektrum der Funktionsschicht neben den kubischen (fcc) CrN und kubischen(fcc) AIN Peaks in der Röntgenbeugung zusätzlich noch Zusatzpeaks von mindestens einem Oxid aufweist, wie in Figur 1 gezeigt. Besonders vorteilhaft ist, wenn der Peak von einem Cr-O stammt und/oder von einem Al-Cr-O, das hexagonale Struktur aufweist.

Als Erklärung kann hierzu angeführt werden, dass das Röntgenbeugungsdiagramm beispielsweise von synthetisierten Al-Cr-O-N Schichten charakterisiert ist durch die Reflexe des kubisch flächenzentrierten (Fm-3m) CrN (03-065-9001) und des kubisch flächenzentrierten (Fm-3m) AIN (00-025-1495) wie in Figur 1 dargestellt. Es wurde gefunden, dass die Existenz dieser beiden kubischen Peaks wichtig ist für eine hohe Schichthärte und einen grossen Wert des Elastizitätsmoduls. Diese beiden Merkmale bestimmen die hohe Erosionsbeständigkeit der Schicht. In Versuchen wurde aber auch herausgefunden, dass dies noch nicht hinreichend für eine gute Korrosionsbeständigkeit ist. Eine reine Al-Cr-N Schicht zeigt keine gute Korrosionsbeständigkeit im Salzsprühtest. Erst die Zugabe von Sauerstoff bei der Synthese von Al-Cr-O-N erhöht die Korrosionsbeständigkeit. In Figur 1 sind neben dem Röntgenbeugungsdiagramm einer reinen Al-Cr-N Schicht auch die Werte für eine Schicht mit 12 at.% O (Al-Cr-O-N gleich 100 at.%) und einer Schicht mit 24 at.% O beispielhaft angegeben. Die Salzsprühkorrosionstests an den 12 at.% O Schichten zeigten zwar bereits eine Verbesserung der Korrosionsbeständigkeit, aber erst der Einbau von 24 at.% O ergab eine Schicht, die im Test exzellente Korrosionsbeständigkeit aufwies. Basierend auf den Röntgenuntersuchungen (Figur 1) liegt das vermutlich daran, dass sich der Sauerstoff nicht nur in die Nitride einlagert durch Verdrängung des Stickstoffs, sondern dass auch Oxide gebildet werden, wie es bei der Röntgenbeugung an der Schicht mit 24 at.% O zu sehen ist, wo sich Cr₂O₃ bildet. Vermutlich kommen dazu noch Anteile von amorphen Aluminiumoxid, das aber in der Röntgenbeugung nicht sichtbar ist. Mit anderen Worten, die Al-Cr-O-N Schicht mit hoher Erosions- und Korrosionsbeständigkeit sollte neben den kubischen Phasen von CrN und AIN, auch die Phase des Cr₂O₃ aufweisen.

Die Beschichtung zu Herstellung der erfindungsgemässen Komponente wird mittels PVD Verfahren, bevorzugt mit reaktiver Funkenverdampfung und Sputtern aufgebracht werden.

Die zu beschichtende Komponentenoberfläche kann eine hochchromhaltige Stahloberfläche sein und/oder eine Ni-Cr, Ni-Co, Ni-Cr-Co-haltige Substratoberfläche sein und/oder eine oder mehrere Superlegierungen enthaltende bevorzugt eine Aluminid-enthaltende (Al-Ni, Al-Ti, Al-Hf) Substratoberfläche sein.

### BEVORZUGTE AUSFÜHRUNGSBEISPIELE

Die Erfindung wird nun im Detail anhand von unterschiedlichen Ausführungsformen und mit Hilfe der Figuren beispielhaft erläutert.
Figur 1 zeigt das Röntgenspektrum der Funktionsschicht einer erfindungsgemässen Schicht,
Figur 2 zeigt schematisch den Schichtaufbau einer ersten Ausführungsform A der vorliegenden Erfindung mit dem Aufbau: Substrate / Cr / AlCr / AlCrO / Al-Cr-O-N, wobei die äusserste Schicht eine Monolagenschicht ist.

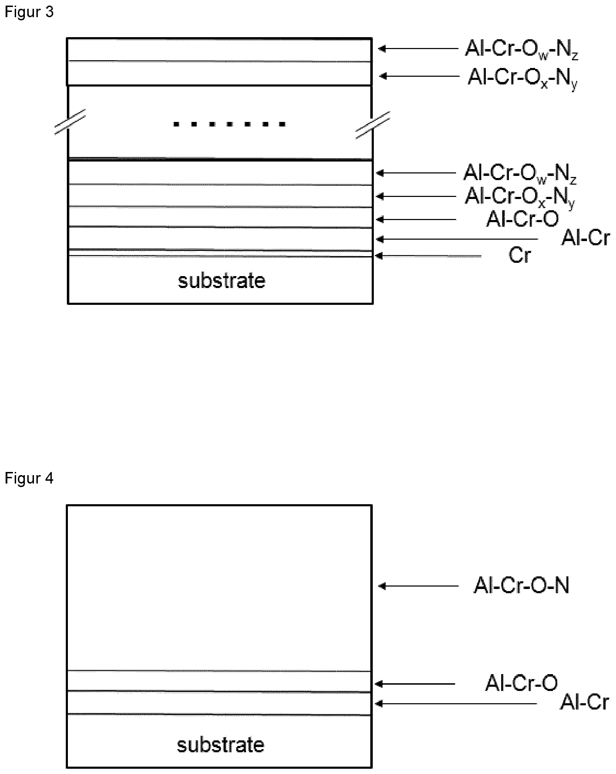

Figur 3 zeigt schematisch den Schichtaufbau einer zweiten Ausführungsform B der vorliegenden Erfindung, mit dem Aufbau: Substrate / Cr / AlCr / AlCrO / Al-Cr-O-N, wobei die äusserste Schicht eine Multilagenschicht ist aus mehreren Einzelschichten erfindungsgemäßer Beschaffenheit, die gemeinsam die außenliegende Funktionsschicht bilden.
Figur 4 zeigt schematisch den Schichtaufbau einer dritten Ausführungsform C der vorliegenden Erfindung mit dem Aufbau: Substrate / AlCr / AlCrO / Al-Cr-O-N wobei die äusserste Schicht eine Monolagenschicht ist.

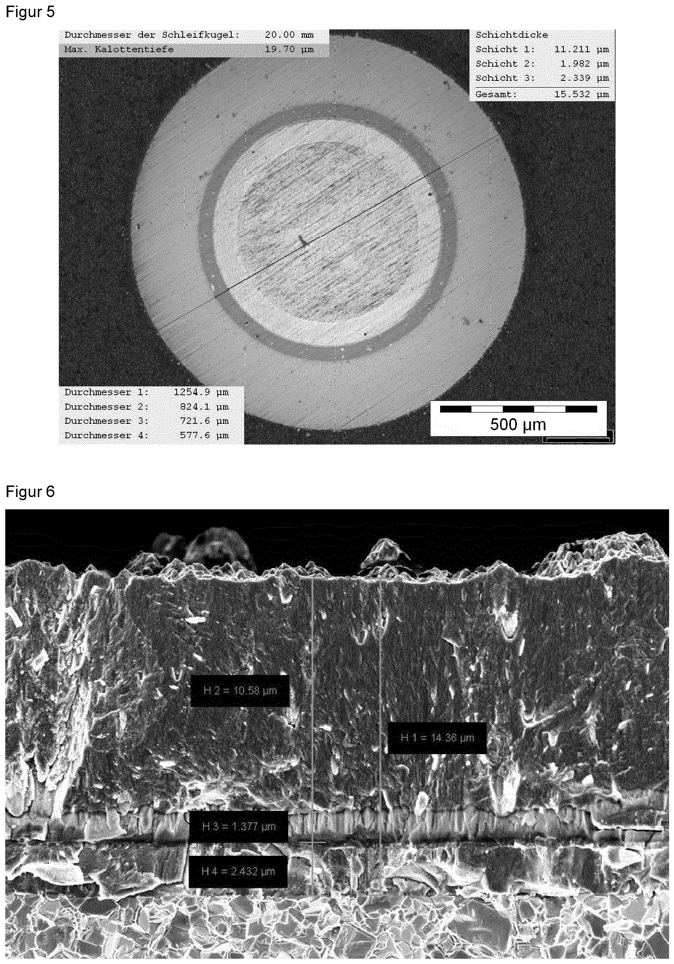

Figur 5 zeigt einen Kalottenschliff eines Schichtsystems gemäss der dritten Ausführungsform
Figur 6 zeigt in einer SEM Aufnahme den Querschnitt eines Schichtsystems gemäss der dritten Ausführungsform

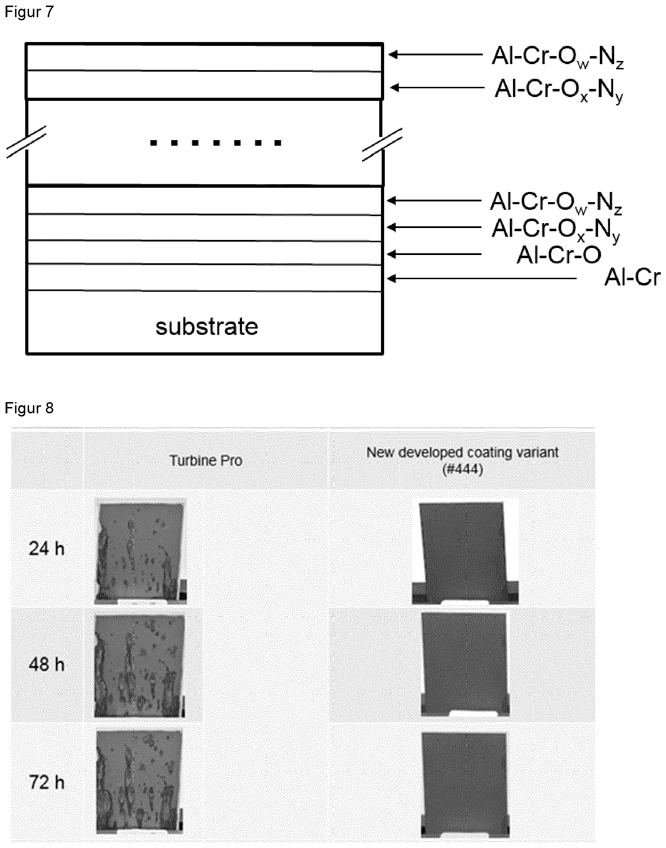

Figur 7 zeigt schematisch den Schichtaufbau einer vierten Ausführungsform D der vorliegenden Erfindung mit dem Aufbau: Substrate / AlCr / AlCrO / Al-Cr-O-N wobei die äusserste Schicht eine Multilagenschicht ist.
Figur 8 zeigt den Vergleich zwischen einer als TurbinPro bezeichneten herkömmlichen, mit TiAIN beschichteten Komponente mit der Ausführungsform C im Salzsprühtest. TurbinPro ist ein kommerziell erhältliches Schichtprodukt der Firma Oerlikon Surface Solutions AG, Schweiz.

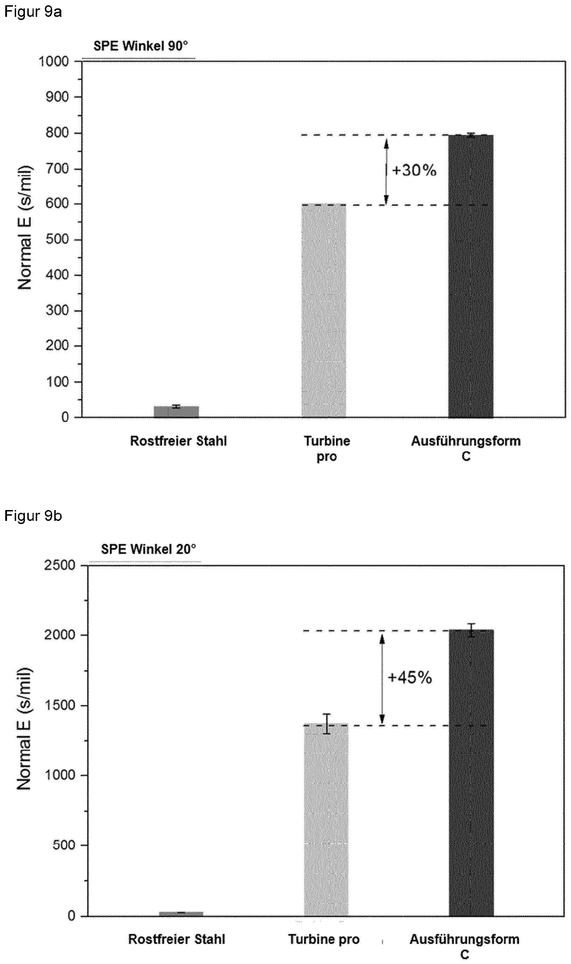

Figur 9a zeigt die Beständigkeit gegen Festkörpererosion für einen Partikeleinfallswinkel von 90° für unterschiedliche Oberflächen
Figur 9b zeigt die Beständigkeit gegen Festkörpererosion für einen Partikeleinfallswinkel von 20° für unterschiedliche Oberflächen

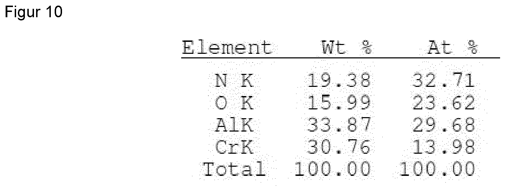

Figur 10 zeigt die chemische Zusammensetzung eines Beispiels eines erfindungsgemässen Schichtsystems

Mittels PVD wird das erfindungsgemässe Schichtsystem (Ausführungsformen A bis D ) auf die Komponente (Gasturbinenschaufel) aufgebracht. Die Varianten A und B besitzen ein zusätzliches Cr-haltiges Schichtinterface zum Substrat hin, während die Varianten C und D ohne dieses Interface auskommen. Die Optimierung von Erosions (solid particle erosion test according to ASTM G76)- und Korrosionsbeständigkeit (z.B. Salzsprühtest nach DIN EN ISO 9227) erfolgt über den Anteil des Sauerstoffs in der Al-Cr-O-N Schicht. Für die Erosionsbeständigkeit sind die Mindestwerte von Schichthärte und Elastizitätsmodul ausschlaggebend, für den Korrosionsschutz der Mindestgehalt an Sauerstoff in der Schicht.

## Patentansprüche

1. Turbinenschaufel einer Turbine, insbesondere einer Gasturbine, wobei die Turbinenschaufel eine Beschichtung zur Erhöhung der Erosions- und der Korrosionsbeständigkeit trägt, wobei die Beschichtung vorzugsweise unmittelbar auf der Turbinenschaufel aufgebracht ist, wobei die Beschichtung aus einer Funktionsschicht und eine Zwischenschicht besteht, wobei die Zwischenschicht zwischen dem Turbinenschaufelsubstrat und der Funktionsschicht angeordnet ist, **dadurch gekennzeichnet, dass** die Funktionsschicht aus den Elementen Al, Cr, O und N besteht, und dass die Zwischenschicht ein Schichtsystem aus Cr und/oder AlCr und/oder Al-Cr-O umfasst.

2. Turbinenschaufel nach Anspruch 1, **dadurch gekennzeichnet, dass** die Zwischenschicht aus einem Schichtsystem aus AlCr und Al-Cr-O besteht.

3. Turbinenschaufel nach einem der vorangehenden Ansprüche, **dadurch gekennzeichnet, dass** die Funktionsschicht eine Monolagenschicht oder eine Multilagenschicht ist.

4. Turbinenschaufel nach Anspruch 3, **dadurch gekennzeichnet, dass** die Funktionsschicht eine Multilagenstruktur umfasst, in der sich das Al/Cr Verhältnis und/oder das O/N Verhältnis über zumindest einen Teil der Schichtdicke periodisch und/oder zumindest über einen Teil der Schichtdicke aperiodisch ändern.

5. Turbinenschaufel nach Anspruch 4, **dadurch gekennzeichnet, dass** das Verhältnis von Al zu Cr (Al/Cr) Atomen in der Funktionsschicht zwischen 4 und 1, bevorzugt zwischen 2 und 1.5 liegt.

6. Turbinenschaufel nach Anspruch 4, **dadurch gekennzeichnet, dass** das Verhältnis von O zu N Atomen (O/N) in der Funktionsschicht zwischen 0.2 und 1.5, bevorzugt zwischen 0.4 und 1 liegt.

7. Turbinenschaufel nach Anspruch 4, **dadurch gekennzeichnet, dass** die Funktionsschicht eine Indentationshärte von mindestens 25 GPa, bevorzugt grösser als 30 GPa aufweist.

8. Turbinenschaufel nach Anspruch 4, **dadurch gekennzeichnet, dass** die Funktionsschicht einen Elastizitätsmodul von mindestens 280 GPa, bevorzugt grösser als 300 GPa aufweist.

9. Turbinenschaufel nach Anspruch 4, **dadurch gekennzeichnet, dass** die Funktionsschicht neben den kubischen CrN und kubischen AlN Peaks in der Röntgenbeugung zusätzlich noch Zusatzpeaks von mindestens einem Oxid aufweist.

10. Verfahren zur Herstellung einer Turbinenschaufel nach Anspruch 1, **dadurch gekennzeichnet, dass** zu deren Herstellung kathodisches Funkenverdampfen und/oder ein Sputterverfahren zum Einsatz kommt und - vorzugsweise unmittelbar - auf der gereinigten Oberfläche der Turbinenschaufel erst eine Zwischenschicht und unmittelbar darauf eine Funktionsschicht abgeschieden wird, die aus den Elementen Al, Cr, O und N besteht.

11. Verfahren nach Anspruch 10 wobei die zu beschichtende Oberfläche eine hochchromhaltigen Stahloberfläche ist und/oder eine Ni-Cr, Ni-Co, Ni-Cr-Co-haltige Substratoberfläche ist und/oder eine oder mehrere Superlegierungen enthaltende, bevorzugt eine Aluminid-enthaltende (Al-Ni, Al-Ti, Al-Hf) Substratoberfläche ist.

## Claims

1. A turbine blade of a turbine, in particular of a gas turbine, wherein the turbine blade has a coating for increasing the erosion and corrosion resistance, wherein the coating is applied preferably directly to the turbine blade, wherein the coating consists of a functional layer and an intermediate layer, wherein the intermediate layer is arranged between the turbine blade substrate and the functional layer, **characterized in that** the functional layer consists of the elements Al, Cr, O and N and that the intermediate layer comprises a layer system made of Cr and/or AlCr and/or Al-Cr-O.

2. The turbine blade according to claim 1 **characterized in that** the intermediate layer consists of a layer system made of AlCr and Al-Cr-O.

3. The turbine blade according to one of the preceding claims **characterized in that** the functional layer is a monolayer or a multilayer.

4. The turbine blade according to claim 3 **characterized in that** the functional layer comprises a multilayer structure in which the Al/Cr ratio and/or the O/N ratio change(s) periodically over at least part of the layer thickness and/or aperiodically over at least part of the layer thickness.

5. The turbine blade according to claim 4 **characterized in that** the ratio of Al to Cr (Al/Cr) atoms in the functional layer is between 4 and 1, preferably between 2 and 1.5.

6. The turbine blade according to claim 4 **characterized in that** the ratio of O to N atoms (O/N) in the functional layer is between 0.2 and 1.5, preferably between 0.4 and 1.

7. The turbine blade according to claim 4 **characterized in that** the functional layer has an indentation hardness of at least 25 GPa, preferably greater than 30 GPa.

8. The turbine blade according to claim 4 **characterized in that** the functional layer has a modulus of elasticity of at least 280 GPa, preferably greater than 300 GPa.

9. The turbine blade according to claim 4 **characterized in that**, in addition to cubic CrN and cubic AIN peaks in X-ray diffraction, the functional layer also has additional peaks of at least one oxide.

10. A method for producing the turbine blade according to claim 1 **characterized in that** cathodic spark evaporation and/or a sputtering method is used for its production and first an intermediate layer is deposited - preferably directly - on the cleaned surface of the turbine blade and a functional layer consisting of the elements Al, Cr, O and N is deposited directly thereafter.

11. The method according to claim 10, wherein the surface to be coated is a highchromium steel surface and/or a substrate surface containing Ni-Cr, Ni-Co, Ni-Cr-Co and/or a substrate surface containing one or more super alloys, preferably a substrate surface containing an aluminide (Al-Ni, Al-Ti, Al-Hf).

## Revendications

1. L'aube de turbine d'une turbine, notamment d'une turbine à gaz, l'aube de turbine comportant un revêtement servant à augmenter la résistance à l'érosion et à la corrosion, le revêtement étant appliqué de préférence directement sur l'aube de turbine, le revêtement étant constitué d'une couche fonctionnelle et d'une couche intermédiaire, la couche intermédiaire étant disposée entre le substrat de l'aube de turbine et la couche fonctionnelle, **caractérisée en ce que** la couche fonctionnelle est constituée des éléments Al, Cr, O et N, et **en ce que** la couche intermédiaire comprend un système de couches comportant Cr et/ou AlCr et/ou Al-Cr-O.

2. L'aube de turbine selon la revendication 1, **caractérisée en ce que** la couche intermédiaire est constituée d'un système de couches comportant AlCr et Al-Cr-O.

3. L'aube de turbine selon l'une quelconque des revendications précédentes, **caractérisée en ce que** la couche fonctionnelle est une monocouche ou une multicouche.

4. L'aube de turbine selon la revendication 3, **caractérisée en ce que** la couche fonctionnelle comprend une structure multicouche dans laquelle le rapport Al/Cr et/ou le rapport O/N change de façon périodique sur au moins une partie de l'épaisseur de la couche et/ou de façon apériodique sur au moins une partie de l'épaisseur de la couche.

5. L'aube de turbine selon la revendication 4, **caractérisée en ce que** le rapport des atomes Al aux atomes Cr (Al/Cr) dans la couche fonctionnelle est compris entre 4 et 1, de préférence entre 2 et 1,5.

6. L'aube de turbine selon la revendication 4, **caractérisée en ce que** le rapport des atomes O aux atomes N (O/N) dans la couche fonctionnelle est compris entre 0,2 et 1,5, de préférence entre 0,4 et 1.

7. L'aube de turbine selon la revendication 4, **caractérisée en ce que** la couche fonctionnelle a une dureté d'indentation d'au moins 25 GPa, de préférence supérieure à 30 GPa.

8. L'aube de turbine selon la revendication 4, **caractérisée en ce que** la couche fonctionnelle a un module d'élasticité d'au moins 280 GPa, de préférence supérieur à 300 GPa.

9. L'aube de turbine selon la revendication 4, **caractérisée en ce que**, outre les pics cubiques CrN et les pics cubiques AIN, la couche fonctionnelle a en plus des pics supplémentaires d'au moins un oxyde en diffraction des rayons X.

10. Procédé de fabrication d'une aube de turbine selon la revendication 1, **caractérisé en ce qu'**une évaporation cathodique par étincelle et/ou un procédé de pulvérisation est utilisé pour sa fabrication et d'abord une couche intermédiaire est déposée - de préférence immédiatement - sur la surface nettoyée de l'aube de turbine et une couche fonctionnelle constituée des éléments Al, Cr, O et N est déposée immédiatement après.

11. Le procédé selon la revendication 10, la surface à revêtir étant une surface d'acier à forte teneur en chrome et/ou une surface de substrat contenant Ni-Cr, Ni-Co, Ni-Cr-Co et/ou une surface de substrat contenant un ou plusieurs super-alliages, de préférence une surface de substrat contenant un aluminure (Al-Ni, Al-Ti, Al-Hf).
